# EUROPEAN PATENT APPLICATION

(11) **EP 1 047 133 A1**
(43) Date of publication of application: **25.10.2000**
(21) Application number: 99830238.4
(22) Date of filing: 23.04.1999
(51) Int. Cl.: H01L 27/06, H01L 29/739, H01L 21/331

(54) **Method for producing devices for control circuits integrated in power devices**

(71) Applicant: STMicroelectronics S.r.l., 20041 Agrate Brianza (Milano) (IT)
(72) Inventor: Fragapane, Leonardo, 95100 Catania (IT)
(74) Representative: Modiano, Guido, Dr.-Ing.

(57) **Abstract**

A method for producing devices for control circuits integrated in power devices, the particularity of which is the fact that it comprises the steps that consist in:
forming a signal device inside an active area of a power device in a chip;
forming, by means of an implantation, an edge structure of the signal device and providing, by means of the implantation of the edge structure, at the active area of the signal device, a P-type well at a lower concentration than wells of holes arranged at the source and drain regions of the signal device, the well of holes providing electrical continuity between the drain and source regions of the signal device.

## Description

The present invention relates to a method for producing devices for control circuits integrated in power devices, such as for example PMOS and IGBT devices.

It is known that the need to integrate signal devices within the active area of power devices (such as PMOS and IGBT devices) arises from the possibility to provide, on the same chip, a circuit which allows to control the operating conditions of the power device, to the point of performing a complete power-off of said device in case of abnormal operation.

The control circuit of the power device is generally produced by using resistors, diodes, temperature and/or current sensors and signal transistors.

The resistors and diodes are generally made of polysilicon, whereas it is preferable to use MOS transistors instead of bipolar transistors for the signal transistor, not only because is it simpler to drive a MOS transistor but also because said transistors introduce a smaller number of parasitic elements than bipolar transistors.

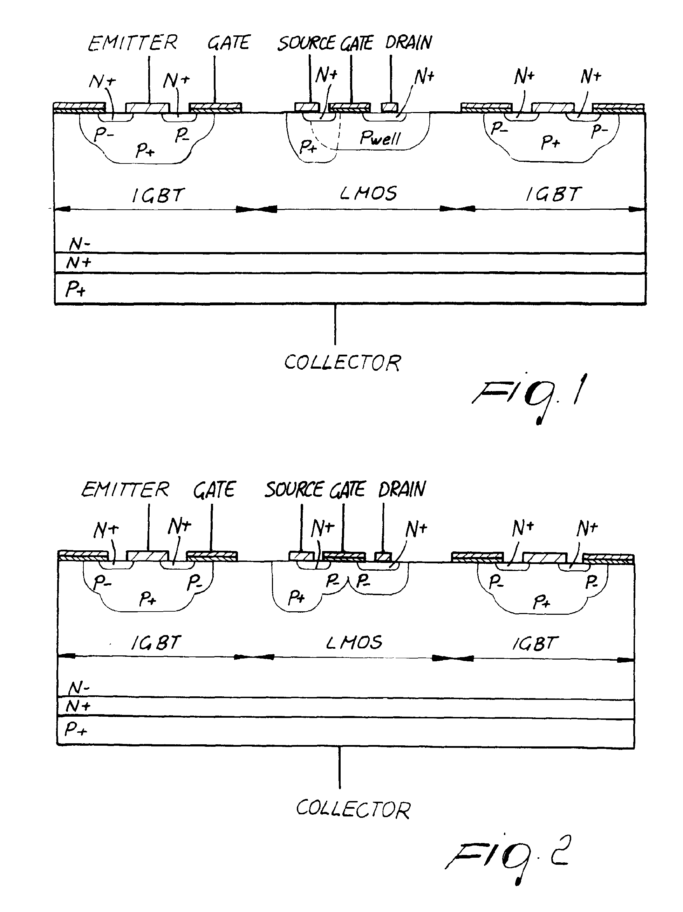

Accordingly, the production of MOS signal transistors entails, in the simplest case, the addition of three process steps, generally just before the gate oxidation step: a masking step, followed by a P-well implantation step and by a relative diffusion step. The final structure is the one shown in figure 1, which however illustrates the case of an IGBT power device in the active area of which the MOS signal transistor, designated by the reference sign LMOS, is arranged.

A second solution for producing the circuit described above which has the advantage of not introducing additional steps allows to use the lateral diffusion of the body of the transistor so as to join the two adjacent P⁻ wells, thus providing electrical continuity below the gate of the LMOS transistor, as shown in figure 2.

Said figure in fact clearly shows that the adjacent P-type wells are connected so as to provide an electrical continuity below the gate of the LMOS transistor.

The solution shown in figure 2 in any case has the drawback of limiting the maximum width of the gate to the value L £ 2 Xjₗₐₜ of the body of the transistor and therefore it is difficult to use because it is strictly dependent on the power device production processes: implantation doses, photomasking resolution, diffusion times and temperatures.

If the power device is an IGBT, as shown in figures 1 and 2, other drawbacks add to the above described ones: in particular, the fact that the injection of the holes from the rear (P⁺ layer), by reaching the surface of the signal MOS (LMOS), can significantly alter the static and dynamic behavior of said MOS. Furthermore, the presence below the passive components (resistors and diodes) of body holes, required in order to avoid altering the distribution of the electrical field in the active area, may cause the hole current to concentrate in said regions, triggering latch phenomena.

The aim of the present invention is to provide a method for producing devices for control circuits integrated in power devices in which the width of the gate of the signal device is variable at will, without hindrance to the electrical continuity between the drain and the source.

Within the scope of this aim, an object of the present invention is to provide a method for producing devices for control circuits integrated in power devices in which the injection of the holes in the regions where the control circuit is provided does not significantly alter the static and dynamic behavior of the signal device.

Another object of the present invention is to provide a method for producing devices for control circuits integrated in power devices, wherein the lifetime of the carriers in the region where the control circuit is integrated is reduced, in order to reduce the injection of holes only in the region meant to provide the control circuit, leaving the remaining chip area unchanged.

Another object of the present invention is to provide a method for producing devices for control circuits integrated in power devices which is highly reliable, relatively easy to execute and at competitive costs.

This aim, these objects and others which will become apparent hereinafter are achieved by a method for producing devices for control circuits integrated in power devices, characterized in that it comprises the steps that consist in:
forming a signal device inside an active area of a power device in a chip;
forming, by means of an implantation, an edge structure of said signal device and providing, by means of said implantation of said edge structure, at the active area of said signal device, a well of holes at a lower concentration than wells of holes arranged at the source and drain regions of said signal device, said well of holes providing electrical continuity between the drain and source regions of said signal device.

Further characteristics and advantages of the invention will become apparent from the description of preferred but not exclusive embodiments of the method according to the present invention, illustrated only by way of non-limitative example in the accompanying drawings, wherein:
Figure 1 is a diagram of the final structure of a signal device integrated in the active area of a power device, according to the prior art;
Figure 2 is a diagram of another final structure of a signal device integrated within the active area of power devices, according to a second embodiment of the prior art;
Figure 3 is a diagram of the configuration of a signal device inside the active area of a power device, executed with the method according to the present invention; and
Figure 4 is a diagram, similar to Figure 3, of a second embodiment of the method according to the present invention.

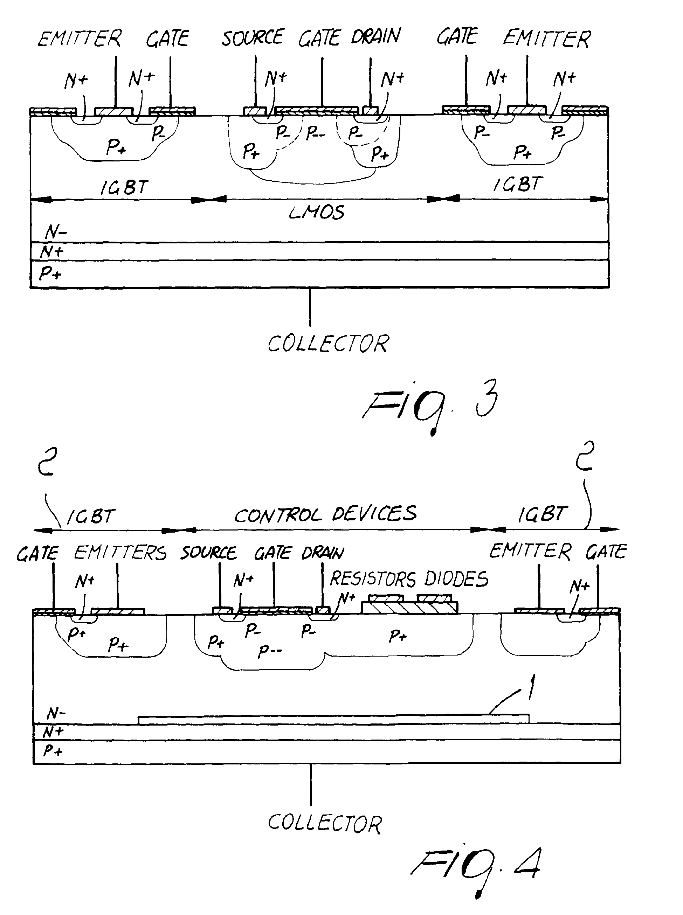

With reference therefore to the above figures, and particularly to Figures 3 and 4 (since Figures 1 and 2 have already been described), the method according to the present invention allows to solve the problem related to the production of signal devices (LMOS) integrated in active areas of power devices (for example PMOS and IGBT devices) and to control the injection of holes in the regions where the control circuit is provided.

The drawback of the known art of having a limit to the maximum width of the gate of the signal device (LMOS) is obviated, according to the invention, by utilizing the implantation used to provide the edge structure of the signal device to obtain a P⁻⁻-doped well located below the active region of the LMOS signal device.

In this case, there are no set limits to the width of the gate of the signal device, since regardless of the production process used an electrical continuity is provided between the drain and the source without the presence of the P⁻⁻-doped well (by virtue of its doping concentration, which is lower than P⁻) significantly altering the electrical characteristics of the signal MOS (LMOS).

This described solution is particularly advantageous if one uses a fast diffuser, such as for example aluminum, to provide the edge ring.

In this case, diffusion temperature being equal, it is possible to obtain a P⁻⁻ well which is much deeper than the P⁺ well located below the source and drain regions, respectively, as shown in Figure 3.

The presence of a deep well arranged below the signal device (LMOS), by increasing the thickness of the base of the parasitic transistor N⁺P⁻N⁻, significantly decreases its gain, further limiting any parasitic effects thereof.

If the power device is an IGBT, since the P⁻⁻ well is surrounded by a P⁺ ring and is physically coupled to the ring, a channel is provided for extracting the holes injected from the rear (i.e., at the P⁺ layer 1) in the active region of the LMOS signal device, attenuating the parasitic effects of the vertical PNP transistor.

In this manner, the holes find a path toward the P⁺ and are collected by the emitter of the IGBT, to which the P⁺ is connected by means of the source metalization without reaching the operating region of the lateral MOS and therefore without affecting operation.

The deep P⁻⁻ well therefore allows on the one hand a more uniform distribution of the electrical fields inside the chip and on the other hand avoids an abnormal concentration of holes under the LMOS signal device and therefore any localized latch-up of the parasitic PNP, which might lead to noise in the structure.

Another improvement can be provided by reducing the lifetime of the charge carriers locally, only in the region where the control circuit is integrated, as shown in Figure 4, wherein the reference numeral 1 designates the extension of the region where the carrier lifetime is reduced.

Such lifetime reduction can be performed by means of an implantation of a noble gas with high energy, such as for example helium, which allows to drastically reduce the injection of holes only in the region where the control circuit is to be provided (the extension of said area being designated by the reference numeral 1), leaving unchanged the injection of holes in the area of the chip 2 intended for the conduction of the main IGBT and accordingly maintaining its static and dynamic electrical characteristics.

In practice it has been found that the method according to the invention fully achieves the intended aim and objects, since it allows to eliminate the drawbacks in terms of limitation of the maximum width of the gate of the signal device and to control the injection of holes in the regions of the chip where the control circuit is provided.

The method thus conceived is susceptible of numerous modifications and variations, all of which are within the scope of the inventive concept; all the details may furthermore be replaced with other technically equivalent elements.

Where technical features mentioned in any claim are followed by reference signs, those reference signs have been included for the sole purpose of increasing the intelligibility of the claims and accordingly such reference signs do not have any limiting effect on the interpretation of each element identified by way of example by such reference signs.

## Claims

1. A method for producing devices for control circuits integrated in power devices, characterized in that it comprises the steps that consist in:
forming a signal device inside an active area of a power device in a chip;
forming, by means of an implantation, an edge structure of said signal device and providing, by means of said implantation of said edge structure, at the active area of said signal device, a P-type well at a lower concentration than P-type wells arranged at the source and drain regions of said signal device, said P-type well providing electrical continuity between the drain and source regions of said signal device.

2. The method according to claim 1, characterized in that said P-type well at a lower concentration than P-type wells located at the drain and source regions of said signal device is deeper than said P-type wells of the drain and source regions.

3. The method according to claim 2, characterized in that said P-type well at a lower concentration and greater depth than the P-type wells connected thereto and arranged at the drain and source regions of the signal device is provided by diffusing aluminum in order to form the edge structure of said signal device.

4. The method according to claim 1, characterized in that it comprises a step for the implantation of a noble gas with high energy, at the region of said chip that is meant to provide a control circuit integrated in a power device, in order to reduce the injection of holes in the area reserved for the provision of said signal device that belongs to the control device.

5. The method according to claim 4, characterized in that said noble gas is helium.

6. A control circuit of a power device, provided on the same chip as said power device, characterized in that it comprises a signal device which has, at the active area of said signal device, a P-type well at a lower concentration than P-type wells arranged at the source and drain regions of said signal device, said P-type well providing electrical continuity between the drain and source regions of said signal device.

7. The control circuit according to claim 6, characterized in that said P-type well at a lower concentration than P-type wells arranged at the drain and source regions of said signal device is deeper than said P-type wells of the drain and source regions.

8. The control circuit according to claim 7, characterized in that said P-type well at a lower concentration than the P-type wells arranged at the drain and source regions is coupled to said P-type wells.

9. The control circuit according to claim 6, characterized in that it has, at the active region of said signal device, an implantation in order to reduce the lifetime of the carriers in said active region and accordingly reduce the injection of holes in said active region.
